Europäisches Patentamt

European Patent Office

Office européen des brevets

(19)

(11) Veröffentlichungsnummer: **0 086 360**
**B1**

(12) **EUROPÄISCHE PATENTSCHRIFT**

(45) Veröffentlichungstag der Patentschrift: 09.11.88

(51) Int. Cl.⁴: **G 11 C 11/34, G 11 C 17/00**

(21) Anmeldenummer: 83100647.3

(22) Anmeldetag: 25.01.83

(54) **Wortweise elektrisch umprogrammierbarer nichtflüchtiger Speicher sowie Verwendung eines solchen Speichers.**

(30) Priorität: 16.02.82 DE 3205476

(43) Veröffentlichungstag der Anmeldung:
24.08.83 Patentblatt 83/34

(45) Bekanntmachung des Hinweises auf die
Patenterteilung:
09.11.88 Patentblatt 88/45

(84) Benannte Vertragsstaaten:
AT CH DE FR GB IT LI SE

(56) Entgegenhaltungen:
GB-A-1 494 732
PATENTS ABSTRACTS OF JAPAN, Band 6, Nr.
34 (P-104)912r, 2. März 1982
PATENTS ABSTRACTS OF JAPAN, Band 4, Nr.
91 (E-17)573r, 28. Juni 1980, Seite 65 E 17

(73) Patentinhaber: Siemens Aktiengesellschaft
Berlin und München
Wittelsbacherplatz 2
D-8000 München 2 (DE)

(72) Erfinder: Schrenk, Hartmut, Dr. Dipl.-Phys.
Fasanenweg 22
D-8013 Haar (DE)

Courier Press, Leamington Spa, England.

**Beschreibung**

Die Erfindung betrifft einen wortweise elektrisch umprogrammierbaren nichtflüchtigen Speicher mit matrix-förmig angeordneten und Speichertransistoren aufweisenden Speicherzellen- sowie die Verwendung eines solchen Speichers.

Entsprechende nichtflüchtige Speicher sind z.B. aus der DE—PS 24 45 137 (US—PS 4 087 795) oder der Zeitschrift Electronics, 28. Feb. 1980, Seiten 113 bis 117, bekannt. Die Verwendung der im allgemeinen als EEPROMs bekannten, nichtflüchtigen und elektrisch umprogrammierbaren Speicher ist in der Praxis Einschränkungen unterworfen. Zum einen erfordert die elektrische Umprogrammierung eine beträchtliche Keit, die bei handelsüblichen Produkten dieser Art zwischen 1 ms und 1 s liegt. Zum anderen führt das elektrische Umprogrammieren zu einer Alterung der EEPROMs, was sowohl die Programmiereigenschaften als auch die Datenerhaltung verschlechtert.

In vielen Anwendungen der nichtflüchtigen Abspeicherung von Daten werden einzelne Teile der abzuspeichernden Information definiert häufiger geändert. Gleichzeitig sind für sie die Anforderungen an die Datenerhaltung geringer. Das ist z.B. im Falle des elektronischen Zählers mit nichtflüchtiger Speicherung des Zählerstandes, beispielsweise eines elektronischen Kilometerzählers, unmittelbar einzusehen. Die höherwertigen Ziffern des Zählerstandes werden selten umprogrammiert. Programmierzeit und zulässige Umprogrammierhäufigkeit spielen daher eine untergeordnete Rolle. Entscheidend ist aber eine gute Langzeit-Datenerhaltung. Die unteren Ziffern des Zählerstandes ändern sich häufig. Kurze Programmierzeit und große zulässige Anzahl von Umprogrammierungen sind wichtiger als die Datenerhaltung über lange Zeiten hinweg.

Dieses Problem konnte bischer nicht befriedigend gelöst werden. Man hat einerseits Speicher, wie z.B. die MNOS-Speicher, verwendet, die von vornherein zwar eine große Anzahl zulässiger Umprogrammierungen besitzen, jedoch eine schlechte Datenerhaltung aufweisen. Andererseits hat man für die häufigen veränderten Informationen nacheinander verschiedene Adressbereiche des EEPROM-Speichers angesprochen, was jedoch wiederum den Speicherplatzbedarf erhöht.

Versteht man unter der Breite des Lesefensters eines EEPROM-Speichers den Abstand der am Gate der Speichertransistoren zu messenden Einsatzspannungen (Schwellspannungen) in gelöschtem und geschriebenen bzw. unprogrammierten und programmierten Zustand, so muß die am Gate eines Speichertransistors anzulegende Auslesespannung innerhalb dieses Lesefensters liegen. Die vorliegende Erfindung geht nun von der Tatsache aus, daß die Breite des Lesefensters die Anzahl der zulässigen Umprogrammierungen von Speicherzellen auf mehrfache Weise beeinflußt.

Die Schädigung einer Speicherzelle hängt nämlich zum einen von der Dauer der anliegenden Lösch- bzw. Schreibspannung und damit direkt von der Breite des Lesefensters ab.

Die Erfindung geht nun von der Idee aus, daß sich durch Kontrolle der Umprogrammiervorgänge über die Breite des Lesefensters die Alterung des Speicherzellen herabsetzen läßt und man außerdem den Vorteil der kürzeren minimalen Programmierzeit für ein kleineres Lesefenster hat, dafür jedoch als Nachteil einen geringeren Sicherheitsabstand gegenüber Datenverlusten in Kauf nehmen muß.

Ausgehend von dieser Idee löst die Erfindung die gestellte Aufgabe der Abspeicherung von mit unterschiedlicher Häufigkeit und unterschiedlichen Anforderungen an die Datenerhaltung auftretenden Daten, wie z.B. kurze Programmierzeit bei häufig auftretenden Daten und hohe Datenerhaltung bei seltener auftretenden Daten, bei einem Speicher der eingangs genannten Art dadurch, daß die Lesefensterbreite der Speichertransistoren der Speicherzellen in mindestens zwei Teilbereichen des Speichers unterschiedlich breit sind.

Damit wird die elektrische Umprogrammierung eines EEPROMs in der Weise vorgenommen, daß die, die Speicherung bewirkende, nichtflüchtige Verschiebung der Einsatzspannung eines Speichertransistors in positiver oder negativer Richtung während des Umprogrammierens für Teilbereiche des Speicherfeldes in unterschiedlichem Ausmaß erfolgt. Die Speicherzellen, die seltener umprogrammiert werden, aber eine zuverlässige Datenerhaltung erfordern, können mit breitem Lesefenster umgeschrieben werden, während die Speicherzellen, die häufig umprogrammiert werden müssen, deren Datenerhaltung aber von vergleichbar geringerer Bedeutung ist, dagegen ein schmaleres Lesefenster erhalten können. Somit gelingt es zum einen Alterungserscheinungen erheblich zu reduzieren und zum anderen die Programmierzeiten deutlich zu verringern.

Vorteilhafterweise arbeitet die Ansteuerschaltung für Löschen und Schreiben für jeden Teilbereich des Speichers mit unterschiedlicher Lösch- bzw. Schreibdauer.

Hierzu ist es von Vorteil, daß das Ende der Lösch- bzw. Schreibdauer durch die Kontrolle des Erreichens eines vorgegebenen Lösch- bzw. Schreibzustandes mindestens einer Speicherzelle aus dem zu löschenden bzw. zu schreibenden Teilbereich des Speichers festlegbar ist, daß das Erreichen des vorgegebenen Löschzustandes durch Vergleich der Schwellspannung des Speichertransistors mit einer vorgegebenen Löschkontrollspannung festlegbar ist und daß für jeden Teilbereich des Speichers eine unterschiedlich hohe Löschkontrollspannung vorgesehen ist, und daß das Erreichen des vorgegebenen Schreibzustandes durch Vergleich der Schwellspannung des Speichertransistors mit einer vorgegebenen Schreibkontrollspannung festlegbar ist und daß für jeden Teilbereich des Speichers

eine unterschiedliche hohe Schreibkontrollspannung vorgesehen ist.

Weiterhin liegt es im Rahmen der Erfindung, daß jeder Teilbereich des Speichers mit unterschiedlich hohen Programmierspannungen beim Löschen und Schreiben ansteuerbar ist, und daß die Speicherzellen jedes Teilbereiches technologisch unterschiedlich ausgeführt sind.

Der erfindungsgemäße Speicher kann insbesondere als elektronischer Zähler mit nichtflüchtiger Abspeicherung des Zählerstandes verwendet werden, wobei vorteilhafterweise zwei Teilbereiche des Speichers vorgesehen sind und wobei das Lesefenster im ersten Teilbereich um mindestens eine Größenordnung größer als im zweiten Teilbereich gewählt ist.

Die Erfindung wird im folgenden anhand der Figuren näher erläutert. Es zeigen:

Fig. 1 das Schaltbild eines Ausführungsbeispiels eines erfindungsgemäßen Speichers,

Fig. 2 den zeitlichen Verlauf der Schwellenspannung eines Speichertransistors sowie Lösch- und Schreibzeit bei breitem Lesefenster und

Fig. 3 den zeitlichen Verlauf der Schwellenspannung eines Speichertransistors sowie Löschzeit und Schreibzeit bei schmalem Lesefenster.

In den Figuren sind gleiche Elemente mit gleichen Bezugszeichen versehen.

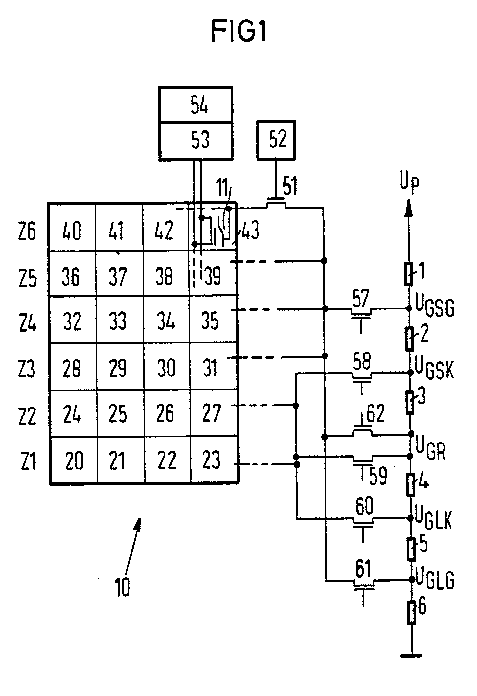

Das in der Fig. 1 gezeigt Schaltbild zeigt ausschnittsweise ein Ausführungsbeispiel eines elektrischen Zählers mit nichtflüchtiger Abspeicherung von 6 Zähldekaden in einem EEPROM. Das EEPROM 10 besteht in diesem Fall aus 24 matrixförmig angeordneten und je einen Speichertransistor 11 aufweisenden Speicherzellen 20 bis 43. Eine Speicherzelle kann auch—wie aus Electronics, 28. Feb. 1980, Seiten 113 bis 117, bekannt—aus einem Speichertransistor 11 und einem in der Fig. 1 aus Gründen der Übersichtlichkeit nicht dargestellten Auswahltransistor bestehend. Jeweils vier Speicherzellen und damit vier Bit bilden eine Zähldekade, so daß mit den als Zeilen angeordneten 6 Zähldekaden $Z_1$ und $Z_6$ bei Verwendung eines BCD-Code 6 Ziffern abgespeichert werden können. Ein solcher Zähler kann z.B. als Kilometerzähler verwendet werden. In der Figur ist aus Gründen der Übersichtlichkeit nur ein Speichertransistor 11 dargestellt.

Erfindungsgemäß weisen die Speichertransistoren 11 der Speicherzellen des Speichers 10 in zwei Teilbereichen des Speichers 10 unterschiedlich breite Lesefenster auf. Im gezeigten Fall ist für die zu den Zähldekaden $Z_3$ bis $Z_6$ gehörigen Speicherzellen 28 bis 43 ein breites Lesefenster und für die zu den Zähldekaden $Z_1$ und $Z_2$ gehörenden Speicherzellen 20 bis 27 ein schmales Lesefenster vorgesehen, wobei unter Lesefenster die (betragsmäßige) Differenz von Einsatzspannung eines Speichertransistors 11 im programmierten Zustand und Einsatzspannung im unprogrammierten Zustand verstanden wird.

Die Breite der Lesefenster der Speichertransistoren der Zellen 20 bis 43 kann beispielsweise über eine in der DE—OS 28 28 855 eingehend dargestellte Programmierzeitsteuerung kontrolliert werden. Die in der zitierten Schrift beschriebene Zeitsteuerung arbeitet in der Weise, daß eine Ansteuerschaltung mit der Speichermatrix 10 zusammengeschaltet ist, und daß für jede Speicherzeile $Z_1$ und $Z_6$ variable Lösch- und Schreibdauern vorgesehen sind, deren Ende durch das Erreichen eines vorgegebenen Lösch-bzw. Schreibzustandes einer oder mehrerer Speicherzellen aus der zu löschenden bzw. zu schreibenden Speicherzeile angezeigt wird, wobei der Lösch- bzw. Schreibzustand einer oder mehrerer Speicherzellen der zu löschenden bzw. zu schreibenden Speicherzeile während der Lösch- bzw. Schreibdauer dieser Speicherzeile kontrolliert wird.

Dabei kann die Ansteuerung derart mit der Speichermatrix zusammengeschaltet sein, das zur Erreichung einer variablen Löschdauer einer Speicherzeile und zur Kontrolle des Löschzustandes einer oder mehrerer Speicherzellen der zu löschenden Zeile, die an den Speicherzellen anliegenden Löschspannungen in eine zeitliche Folge von Einzelimpulsen aufgeteilt werden, so daß in dem Impulspausen jeweils ein Kontroll-Lesevorgang eingeschaltet wird. Es kann aber auch ein gleichzeitiges Löschen und Kontrollesen vorgenommen werden.

Die Ansteuerung ist gemäß der DE—OS 28 28 855 ferner derart mit der Speichermatrix zusammengeschaltet, daß der Löschdauer einer Speicherzeile beendet ist, wenn alle Speicherzellen, an denen kontrollgelesen wird, eine Schwellspannung von $U_T$ aufweisen, wobei $U_T$ kleiner oder gleich $U_{GL}$, wenn $U_{GL}$ einen vorgebenen Schwellwert der verwendeten Speicherzellen bedeutet.

Entsprechendes gilt für die Ansteuerschaltung zur Erreichung einer variablen Schreibdauer, die also so ausgeführt ist, daß die Schreibdauer einer Speicherzelle beendet ist, wenn alle Speicherzellen, an denen kontrollgelesen wird, eine Schwellspannung von $U_T$ größer oder gleich $U_{GS}$ aufweisen, wobei $U_{GS}$ eine vorgebbare Schreib-kontrollspannung ist.

Um einen sicheren Mindesabstand zwischen der zum Auslesen benötigten an das Gate des Speichertransistors 11 anzulegenden Gatespannung $U_{GR}$ zu garantieren, werden vorteilhafterweise die Gatespannungen, die als vorgegebene Schwellspannungswerte ($U_{GS}$ und $U_{GL}$) zum Kontrolllesen beim Programmieren und Löschen benötigt werden, sowie die Gatespannung für das Auslesen der Speicherzellen ($U_{GR}$) aus ein-und demselben Spannungsteiler entnommen, so daß stets $U_{GL}$ kleiner als $U_{GR}$ und zugleich $U_{GR}$ kleiner als $U_{GS}$ gilt.

Bezüglich weiterer Details und insbesondere der schaltungstechnischen Realisierung der in der Fig. 1 aus Gründen der Übersichtlichkeit nicht dargestellten Source-Drain-Ansteuerungsschaltungen, der Auswertelogik, der Gateansteuerungsschaltung und der Steuerschaltung mit Impulsteil wird auf die ausführliche Darstellung in der DE—OS 28 28 855 verwiesen.

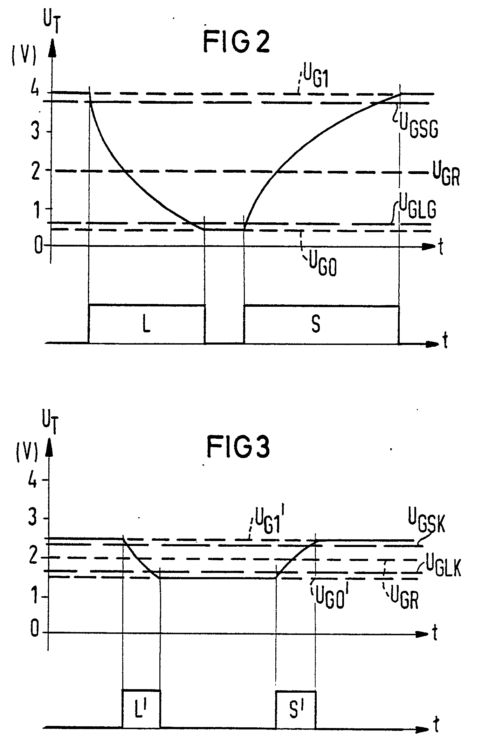

Die Programmierzeitsteuerung wird also so vorgenommen, daß während des Umprogrammierablaufes die jeweilige Lage der Einsatzspannung (Schwellspannung) $U_T$ eines Speichertransistors 11 mit einer vorgegebenen Kontrollesespannung $U_{GLG}$ bzw. einer vorgegebenen Kontrollschreibspannung $U_{GSG}$ verglichen wird, wie im oberen Teil der Fig. 2 dargestellt. Liegt die Schwellspannung $U_T$ oberhalb der Schwellspannung im programmierten Zustand $U_{G1}$, so ist im Falle einer n-Kanal-MOS-Technik der Speichertransistor 11 sicher gesperrt. Für $U_T$ kleiner $U_{G0}$ ($U_{G0}$=Einsatzspannung im unprogrammierten Zustand) ist analog die Speicherzelle sicher leitend. Am Wechsel zwischen leitendem und gesperrtem Zustand ist daher erkennbar, ob die Speicherzelle unter gegebenen Kontrollbedingungen einen gewünschten Programmierzustand erreicht hat. Durch Festlegung der Kontrollspannungen $U_{GSG}$ und $U_{GLG}$ werden damit die Spannungen $U_{G1}$ bzw. $U_{G0}$ und damit die Breite des Lesefensters gegenüber der Auslesespannung $U_{GR}$ festgelegt. Somit sind die Einsatzspannungen der Speicherzelle beim Löschen bzw. Schreiben definiert einstellbar. Die benötigten Löschdauern L und Schreibdauern S sind im unteren Teil der Fig. 2 dargestellt.

Für die oberen Ziffern des Zählers, z.B. wie im Ausführungsbeispiel angenommen für die Zähldekaden $Z_3$ bis $Z_6$, wählt man im Hinblick auf die Datenerhaltung ein breites Lesefenster, das im Falle eines Floating-Gate-Speichers einige Volt beträgt, d.h. das Lesefenster in Fig. 2 ($U_{G1}$—$U_{G0}$) beträgt einige Volt. Für die niederwertigen Ziffern, d.h. die Zähldekaden $Z_1$ und $Z_2$ sind die Anforderungen an die Datenerhaltung geringer. Es genügt—wie in der Fig. 3 gezeigt—ein reduziertes Lesefenster ($U_{G1}'$—$U_{G0}'$) von wenigen Zehntel Volt.

Ein solches reduziertes Lesefenster wird durch die Wahl von Schreibkontrollspannung $U_{GSK}$ und Lesekontrollspannung $U_{GLK}$ erreicht, wobei die Kontrollspannungen im Vergleich zu den Kontrollspannungen bei großem Lesefenster $U_{GSG}$ und $U_{GLG}$ näher an der Lesespannung $U_{GR}$ liegend gewählt werden. Mit dem geringeren Lesefenster verringert sich—wie in der Fig. 3 unten gezeigt—die Löschdauer L' und die Schreibdauer S'.

Wegen des asymptotischen Verlaufs der Lösch- bzw. Schreibkurven ist der Einfluß des kleineren Lesefensters auf die Programmierdauer, wie den Figuren 2 und 3 zu entnehmen ist, groß. Die Reduzierung der maximalen Potentialdifferenzen durch die Isolationsschichten des Speichertransistors um die Beträge ($U_{G1}$—$U_{G1}'$) bzw. ($U_{G0}'$—$U_{G0}$) bei festen äußeren Spannungen verbessert das Alterungsverhalten darüber hinaus so stark, daß eine zulässige Programmierhäufigkeit von $10^4$ Programmierzyklen bei Normalbedingungen sich unter erfindungsgemäßen Bedingungen auf $10^6$ erhöht und damit für einen 6-Dekadenzähler ausreicht.

Die Darstellung der Figuren 2 und 3 bezieht sich auf die Verwendung von mittels Kanalinjektion programmierbaren n-Kanal-MOS-Floating-Gate-Speichertransistoren, wie sie auch dem Ausführungsbeispiel der DE—OS 28 28 855 zugrunde liegen. Bei Verwendung von n-Kanal-Transistoren, die mittels eines Tunneleffektes programmiert werden, wie sie z.B. in Electronics, 28. Feb. 1980, Seiten 113 bis 117, beschrieben werden, wird die Schwellenspannung $U_{G1}$ durch den gelöschten und die Schwellenspannung $U_{G0}$ durch den geschriebenen Zustand gekennzeichnet.

Bei Verwendung einer Programmierzeitsteuerung werden die Lesekontrollspannungen und die Schreibkontrollspannungen und die Lesespannung $U_{GR}$ vorteilahfterweise über einen gemeinsamen Spannungsteiler erzeugt, der die Reihenfolge der Spannungen unveränderbar festlegt. Ein entsprechender Spannungsteiler, der aus einer Reihenschaltung der Widerstände 1, 2, 3, 4, 5 und 6 besteht, ist in der Fig. 1 dargestellt. Der Anschluß des Widerstands 1, der nicht mit dem Widerstand 2 verbunden ist, ist an eine Versorgungsspannung $U_P$ angeschlossen, welche größer ist als die Spannungs $U_{GSG}$. Der Anschluß des Widerstandes 6, der nicht mit dem Widerstand 5 verbunden ist, ist gerdet. Zwischen den Widerständen 1 und 2 liegt dann die Kontrollschreibspannung zur Erzeugung eines großen Lesefensters $U_{GSG}$, zwischen den Widerständen 2 und 3 die Schreibkontrollspannung zum Erzeugen eines kleinen Lesefensters $U_{GSK}$, zwischen den Widerständen 3 und 4 die eigentliche Lesespannung $U_{GR}$, zwischen den Widerständen 4 und 5 die Lesekontrollspannung $U_{GLK}$ zur Erzeugung eines kleinen Lesefensters und zwischen den Widerständen 5 und 6 die Lesekontrollspannung $U_{GLG}$ zur Erzeugung eines breiten Lesefensters. Die Kontrollspannungen $U_{GSG}$ und $U_{GLG}$ und die Lesespannung $U_{GR}$ können dann über die Transfergates 57, 62, 59 und ein weiteres, über den Zeilendecodierer der Gate-Aussteuer-Schaltung 52 zu steuerndes Transfergate 51 das Gate eines Speichertransistors 11, der ein breites Lesefenster aufweisensoll, beaufschlagen. Dies trifft für die Zähldekaden $Z_3$ bis $Z_6$ mit den Speicherzellen 28 bis 43 gemäß Fig. 1 zu. Die Gateelektroden der Speichertransistoren mit schmalem Lesefenster (Zellen 20 bis 27) werden über die Transfergates 58, 60 und 59 und ein in der Figur aus Gründen der Übersichtlichkeit nicht dargestelltes, dem Transfergate 51 entsprechendes weiteres Transfergate mit den Spannungen $U_{GSK}$, $U_{GLK}$, und $U_{GR}$ beaufschlagt. Die Ansteuerung der Transfergates 51, 57, 58, 59, 60, 61 und 62 erfolgt mittels einer Gate-Ansteuerungschaltung 52, die der in der DE—OS 28 28 855 beschriebenen Gate-Ansteuerungsschaltung entsprechend ausführbar ist.

Die mit den Source-Anschlüssen und den Drain-Anschlüssen der Speichertransistoren 11 verbundene Auswertlogik 53 und die Source- und Drain-Ansteuerung 54 kann ebenfalls entsprechend der in der DE—OS 28 28 855 beschriebenen Auswertlogik und Source- und Drain-Ansteuerung ausgeführt sein. Für jeden Teilbereich des Speichers 10, der ein unterschiedliches Lesefenster aufweist, ist jedoch eine separate Auswertlogik vorzusehen. Entsprechend ist für jeden Speicherteilbereich, der eine unterschiedliche Lesefensterbreite aufweist, eine unterschiedliche Lesekontrollspannung und eine unterschiedliche Schreibkontrolspannung vorzusehen.

Unterschiedlich breite Lesefenster der Speichertransistoren von Teilbereichen des Speicherfeldes 10 und damit unterschiedlich starke Programmierungen einzelner Teilbereiche des Speicherfeldes können auch durch andere Maßnahmen als die oben dargestellte Programmierzeitregelung erreicht werden.

So können Teilbereich des Speicherfeldes 10 mit unterschiedlich hohen Programmierspannungen beim Löschen und Schreiben angesteurt werden, wobei hohe Programmierspannungen im Vergleich zu geringeren Programmierspannungen zu breiteren Lesefenstern führen.

Weiterhin ist vorgesehen, die Speicherzellen in Teilbereichen des Speicherfeldes so technologisch unterschiedlich auszuführen, daß ihre Lesefenster unterschiedliche Breiten aufweisen. Dies kann durch unterschiedliche geometrische Auslegungen der Speicherzellen in einzelnen Teilbereich erfolgen. So führen geringere Oxiddicken unter dem Floating-Gate zu stärkeren Tunneleffekten und damit zu breiteren Lesefenstern. Eine vergrößerte kapazitive Ankoppelung des Floating-Gates bewirkt beispielsweise ebenfalls eine Vergrößerung des Lesefensters.

Die Anordnungen zum Erreichen der unterschiedlichen Lesefensterbreiten können entweder im Speicherbaustein selber angeordnet sein, es ist aber auch möglich, diese Anordnungen extern vorzusehen und somit z.B. handelsübliche EEPROM-Speicher, bei denen die Gateanschlüsse der Speichertransistoren zugänglich sind, erfindungsgemäß zu betreiben.

Vorteilhafterweise wird bei einem erfindungsgemäßen Speicher, der über zwei Teilbereiche mit unterschiedlicher Lesefensterbreite verfügt, die Lesefensterbreite des einen Teilbereiches um mindestens eine Größenordnung kleiner gewählt als die des anderen Teilbereiches. Die Lesespannung $U_{GR}$ muß nicht in der Mitte des Lesefensters liegen, da die Alterung von EEPROMs aufgrund des sich entladenden programmierten Zustandes unsymmtrisch erfolgt.

Die Erfindung kann sowohl bei EEPROMs, die Floating-Gate-Speicherzellen verwenden, als auch bei anderen EEPROMs, beispielsweise MNOS-Speicherzellen verwenden, angewendet werden.

### Patentansprüche

1. Wortweise elektrisch umprogrammierbarer nicht flüchtiger Speicher mit matrixförmig angeordneten und Speichertransistoren (11) aufweisenden Speicherzellen (20 bis 43), dadurch gekennzeichnet, daß die durch die Schwellspannungsdifferenz zwischen gelöschtem und geschriebenem Zustand gegebene Lesefensterbreite der Speichertransistoren (11) der Speicherzellen (20 bis 43) in mindestens zwei Teilbereichen ($Z_1$, $Z_2$ und $Z_3$ bis $Z_6$) des Speichers (10) unterschiedlich breit sind.

2. Speicher nach Anspruch 1, dadurch gekennzeichnet, daß die Ansteuerschaltung (52) für Löschen und Schreiben für jeden Teilbereich ($Z_1$, $Z_2$ und $Z_3$ bis $Z_6$) des Speichers (10) mit unterschiedlicher Lösch- bzw. Schreibdauer arbeitet.

3. Speicher nach Anspruch 2, dadurch gekennzeichnet, daß das Ende der Lösch- bzw. Schreibdauer durch die Kontrolle des Erreichens eines vorgegebenen Lösch- bzw. Schreibzustandes mindestens einer Speicherzelle (11) aus dem zu löschenden bzw. zu schreibenden Teilbereich ($Z_1$, $Z_2$) des Speichers (10) festlegbar ist.

4. Speicher nach Anspruch 2 oder 3, dadurch gekennzeichnet, daß das Erreichen des vorgegebenen Löschzustandes durch Vergleich der Schwellspannung ($U_T$) des Speichertransistors (11) mit einer vorgegebenen Löschkontrollspannung ($U_{GLG}$) festlegbar ist und daß für jeden Teilbereich ($Z_1$, $Z_2$ und $Z_3$ bis $Z_6$) des Speichers (10) eine unterschiedlich hohe Löschkontrollspannung ($U_{GLG}$, $U_{GLK}$) vorgesehen ist.

5. Speicher nach einem der Ansprüche 2 bis 4, dadurch gekennzeichnet, daß das Erreichen des vorgegebenen Schreibzustandes durch Vergleich der Schwellspannung ($U_T$) des Speichertransistors (11) mit einer vorgegebenen Schreibkontrollspannung ($U_{GSG}$) festlegbar ist und daß für jeden Teilbereich ($Z_1$, $Z_2$ und $Z_3$ bis $Z_6$) des Speichers (10) eine unterschiedlich hohe Schreibkontrollspannung ($U_{GSG}$, $U_{GSK}$) vorgesehen ist.

6. Speicher nach einem der Ansprüche 1 bis 5, dadurch gekennzeichnet, daß jeder Teilbereich ($Z_1$, $Z_2$ und $Z_3$ bis $Z_6$) des Speichers (10) mit unterschiedlich hohen Programmierspannungen ($U_P$) beim Löschen und Schreiben ansteuerbar ist.

7. Speicher nach einem der Ansprüche 1 bis 6, dadurch gekennzeichnet, daß die Speicherzellen (20 bis 43) jedes Teilbereiches ($Z_1$, $Z_2$ und $Z_3$ bis $Z_6$) technologisch unterschiedlich ausgeführt sind.

8. Speicher nach einem der Ansprüche 1 bis 7, dadurch gekennzeichnet, daß zwei Teilbereiche ($Z_1$, $Z_2$ und $Z_3$ bis $Z_6$) des Speichers (10) vorgesehen sind und daß das Lesefenster im ersten Teilbereich ($Z_3$ und $Z_6$) um mindestens eine Größenordnung größer als im zweiten Teilbereich ($Z_1$, $Z_2$), ist.

9. Verwendung des Speichers nach einem der Ansprüche 1 bis 8 als elektronischer Zähler mit nichtflüchtiger Abspeicherung des Zählerstandes.

### Revendications

1. Mémoire rémanente reprogrammable électriquement par mots, comportant des cellules de mémoire (20 à 43) disposée sous la forme d'une matrice et possédant des transistors de mémoire (11), caractérisée par le fait que les fenêtres de lecture, déterminées par la différence des tensions de seuil entre l'état effacé et l'état enregistré, des transistors de mémoire (11) des cellules de mémoire (20 à 43) possèdent des largeurs différentes dans au moins deux zones partielles ($Z_1$, $Z_2$ et $Z_3$ à $Z_6$) de la mémoire (10).

2. Mémoire suivant la revendication 1, caractérisée par le fait que le circuit de commande (52) prévu pour l'effacement et l'enregistrement opère avec des durées différentes d'effacement ou des durées différentes, d'enregistrement pour chaque zone partielle ($Z_1$, $Z_2$ et $Z_3$ à $Z_6$) de la mémoire (10).

3. Mémoire suivant la revendication 2, caractérisée par le fait que la fin de la durée d'effacement ou de la durée d'enregistrement peut être déterminée au moyen du contrôle de l'obtention d'un état prédéterminé d'effacement ou d'enregistrement d'au moins une cellule de mémoire (11) à partir de la zone partielle ($Z_1$, $Z_2$), dans laquelle doit être exécuté l'effacement ou l'enregistrement, de la mémoire (10).

4. Mémoire suivant la revendication 2 ou 3, caractérisée par le fait que l'obtention de l'état d'effacement prédéterminé peut être déterminé par comparaison de la tension de seuil ($U_T$) des transistors de mémoire (11) à une tension prédéterminée de contrôle d'effacement ($U_{GLG}$), et que pour chaque zone partielle ($Z_1$, $Z_2$ et $Z_3$ à $Z_6$) de la mémoire (10), il est prévu des tensions de contrôle d'effacement ($U_{GLG}$, $U_{GLK}$) possédant des valeurs différentes.

5. Mémoire suivant l'une des revendications 2 à 4, caractérisée par le fait que l'obtention de l'état prédéterminé d'enregistrement peut être déterminé par comparaison de la tension de seuil ($U_T$) des transistors de mémoire (11) à une tension prédéterminée de contrôle d'enregistrement ($U_{GSG}$), et que pour chaque zone partielle ($Z_1$, $Z_2$ et $Z_3$ à $Z_6$) de la mémoire (10), il est prévu des tensions de contrôle d'enregistrement ($U_{GSG}$, $U_{GSK}$) possédant das valeurs différentes.

6. Mémoire suivant l'une des revendications 1 à 5, caractérisée par le fait que chaque zone partielle ($Z_1$, $Z_2$ et $Z_3$ à $Z_6$) de la mémoire (10) peut être commandée par des tension de programmation ($U_P$) possédant des valeurs différentes, lors de l'effacement et de l'enregistrement.

7. Mémoire suivant l'une des revendications 1 à 6, caractérisée par le fait que les cellules de mémoire (20 à 43) de chaque zone partielle ($Z_1$, $Z_2$ et $Z_3$ à $Z_6$) sont réalisées différemment du point de vue technologique.

8. Mémoire suivant l'une des revendications 1 à 7, caractérisée par le fait qu'il est prévu deux zones partielles ($Z_1$, $Z_2$ et $Z_3$ à $Z_6$) de la mémoire (10) et que la fenêtre de lecture dans la première zone partielle ($Z_3$ à $Z_6$) est d'une taille supérieure d'au moins un ordre de grandeur à la fenêtre de lecture située dans la seconde zone partielle ($Z_1$, $Z_2$).

9. Utilisation de la mémoire suivant l'une des revendications 1 à 8 en tant que compteur électronique à mémorisation rémanente de l'état de comptage.

## Claims

1. A non-volatile store which can be electrically reprogrammed word-by-word with storage cells (20 to 43) which are arranged in the form of a matrix, and which comprise storage transistors (11), characterised in that the read window breadth of the storage transistors (11) of the storage cells (20 to 43), which is determined by the threshold voltage difference between the erased state and the recorded state, differs in breadth for at least two sub-zones ($Z_1$, $Z_2$ and $Z_3$ to $Z_6$) of the store (10).

2. A store as claimed in Claim 1, characterised in that the drive circuit (52) for erasure and recording operates with a different erasing and recording time for each sub-zone ($Z_1$, $Z_2$ and $Z_3$ to $Z_6$) of the store (10).

3. A store as claimed in Claim 2, characterised in that the end of the erasing and recording time can be determined by checking that a predetermined erasing and recording state has been reached by at least one storage cell (11) of that sub-zone ($Z_1$, $Z_2$) of the store (10) which is to be erased or recorded.

4. A store as claimed in Claim 2 or 3, characterised in that the reaching of the predetermined erasing state can be determined by comparing the threshold voltage ($U_T$) of the storage transistor (11) with a predetermined erase-check voltage ($U_{GLG}$, and that an erase-check voltage ($U_{GLG}$, $U_{GLK}$) of different magnitude is provided for each sub-zone ($Z_1$, $Z_2$ and $Z_3$ to $Z_6$) of the store (10).

5. A store as claimed in one of Claims 2 to 4, characterised in that the reaching of the predetermined recording state can be determined by comparing the threshold voltage ($U_T$) of the storage transistor (11) with a predetermined record-check voltage ($U_{GSG}$), and that a record-check voltage ($U_{GSG}$, $U_{GSK}$) of different magnitude is provided for each sub-zone ($Z_1$, $Z_2$ and $Z_3$ to $Z_6$) of the store (10).

6. A store as claimed in one of Claims 1 to 5, characterised in that each sub-zone ($Z_1$, $Z_2$ and $Z_3$ to $Z_6$) of the store (10) can be driven with programming voltages ($U_P$) of different magnitude for the erasure and recording procedures.

7. A store as claimed in one of Claims 1 to 6, characterised in that the storage cells (20 to 43) of each sub-zone ($Z_1$, $Z_2$ and $Z_3$ to $Z_6$) have a different technological design.

8. A store as claimed in one of Claims 1 to 7, characterised in that two sub-zones ($Z_1$, $Z_2$ and $Z_3$ to $Z_6$) of the store (10) are provided, and that the read window of the first sub-zone ($Z_3$ to $Z_6$) is at least one order of magnitude greater than in the second sub-zone ($Z_1$, $Z_2$).

9. Use of the store as claimed in any of Claims 1 to 8 as an electronic counter with non-volatile storage of the count.

# FIG1

FIG 2

FIG 3